# EUROPEAN PATENT APPLICATION

(11) **EP 2 955 246 A1**
(43) Date of publication of application: **16.12.2015**
(21) Application number: 14749450.4
(22) Date of filing: 22.01.2014
(51) Int. Cl.: C23C 14/08, B32B 9/00

(54) **METHOD FOR PRODUCING TRANSPARENT GAS BARRIER FILM, AND DEVICE FOR PRODUCING TRANSPARENT GAS BARRIER FILM**

(30) Priority: 08.02.2013 JP 2013023299
(71) Applicant: Nitto Denko Corporation, Ibaraki-shi, Osaka 567-8680 (JP)
(72) Inventor: YAMADA, Yasumi, Ibaraki-shi Osaka 567-8680 (JP)
(74) Representative: Grünecker Patent- und Rechtsanwälte PartG mbB
(86) International application number: PCT/JP2014/051188
(87) International publication number: WO 2014/122988

(57) **Abstract**

A method for producing the transparent gas barrier film of the present invention is performed using a roll-to-roll method. The method includes a step of laminating a plurality of thin films of two or more types having different components on a long belt-shaped resin substrate 8 in the course of feeding the resin substrate 8, wherein a plurality of evaporation sources 91 and 92 are disposed in the thin film formation area, the number of evaporation sources being the same as the number of types of the thin films, and the long belt-shaped resin substrate 8 is passed through the thin film formation area and a non-formation area alternately, and materials included in the plurality of evaporation sources 91 and 92 are each deposited on the resin substrate 8 in the thin film formation area to form on the resin substrate 8 a transparent gas barrier layer having the plurality of laminated thin films of two or more types.

## Description

### TECHNICAL FIELD

The present invention relates to a method for producing a transparent gas barrier film using a roll-to-roll method and a production apparatus thereof.

### BACKGROUND ART

Various kinds of electronic devices such as liquid crystal display elements, organic EL elements (EL is an abbreviation of electroluminescence), electronic papers, solar cells, and thin film lithium ion batteries have been becoming lighter and thinner in recent years. It is known that many of these devices are degenerated and degraded by water vapor in the air.

For these devices, glass substrates have been heretofore used as their support substrates. However, use of resin substrates has been contemplated in place of glass substrates because resin substrates are excellent in various kinds of characteristics such as lightness, impact resistance, and flexibility. The resin substrate generally has remarkably high permeability to gases such as water vapor as compared to a substrate formed of an inorganic material such as glass. Therefore, for a resin substrate to be used for the above-mentioned devices, it is required to improve a gas barrier property while maintaining its light permeability.

Electronic devices are required to have an extremely high level of gas barrier property as compared to that in food packaging applications. The gas barrier property is represented by, for example, a water vapor transmission rate (hereinafter, referred to as WVTR). The value of WVTR in conventional food packaging applications is about 1 to 10 g·m⁻²·day⁻¹, whereas it is considered that for example, substrates for thin film silicon solar cell and compound thin film-based solar cell applications are required to have a WVTR of 1 × 10⁻³ g·m⁻²·day⁻¹ or less, and substrates for organic EL element applications are required to have a WVTR of 1 × 10⁻⁵ g·m⁻²·day⁻¹ or less. In order to meet the requirement of such a very high gas barrier property, various methods for forming a gas barrier layer on a resin substrate have been proposed (see, for example, Patent Documents 1 and 2). However, the gas barrier property of an inorganic film formed by a vacuum process represented by those methods cannot satisfy the above-mentioned requirement.

Thus, gas barrier films hybridized by laminating thin films of two or more types having different components by using similar vacuum processes have been proposed (see, for example, Patent Document 3 to 5).

For forming such a gas barrier film having thin films of two or more types by a roll-to-roll method, it is necessary to dispose the same number of evaporation sources (e.g. deposition crucibles, targets or the like) as the number of the layers. For example, when a gas barrier film is formed in which three thin films composed of component A and three thin films composed of component B (components A and B are mutually different) are alternately laminated on a substrate, it is necessary to dispose six evaporation sources, e.g. an evaporation source including component A, an evaporation source including component B, an evaporation source including component A, an evaporation source including component B, an evaporation source including component A, and an evaporation source including component B in the course of feeding a long belt-shaped substrate. When evaporation sources are disposed and the same number of the evaporation sources as the number of layers is the same as described above, there is a problem of increasing equipment and management costs.

On the other hand, a method is also known in which evaporation sources are disposed so as to face a rotating roll and the number of the evaporation sources is the same as the number of types of the thin films, a substrate is attached to the rotating roll in the form of a sheet which is cut in a predetermined size, and materials from the plurality of evaporation sources are sequentially deposited while the rotating roll is rotated. This method is so called a batch production method. According to this method, only the same number of evaporation sources as the number of types of thin films should be installed. For instance, in the case of the above-described example, a plurality of thin films composed of component A and thin films composed of component B can be alternately laminated on a substrate using two evaporation sources: an evaporation source including component A and an evaporation source including component B. In the case of the batch production method, however, it is necessary to exchange evaporation sources (e.g. open/close a shutter, turn on/off evaporation, etc.), and there is a problem of poor production efficiency because a sheet-like substrate which is cut in the predetermined size is used.

[Patent Document 1] JP H08-164595 A
[Patent Document 2] JP 2004-151528 A
[Patent Document 3] JP 2006-68992 A
[Patent Document 4] JP 2007-230115 A
[Patent Document 5] JP 2009-23284 A

### SUMMARY OF INVENTION

An object of the present invention is to provide a method for producing a transparent gas barrier film having an excellent gas barrier property and an apparatus for producing the transparent gas barrier film.

The method for producing the transparent gas barrier film of the present invention is performed using a roll-to-roll method. The method includes laminating a plurality of thin films of two or more types having different components on a long belt-shaped resin substrate in the course of feeding the resin substrate, wherein in the laminating step, a plurality of evaporation sources are disposed in a thin film formation area, the number of the evaporation sources being the same as the number of types of the thin films, and the long belt-shaped resin substrate is passed through the thin film formation area and a non-formation area alternately, and materials included in the plurality of evaporation sources are each deposited on the resin substrate in the thin film formation area to form on the resin substrate a transparent gas barrier layer having the plurality of laminated thin films of two or more types.

In a preferable production method of the present invention, the plurality of evaporation sources are arranged in the thin film formation area, and in the thin film formation area, the resin substrate is fed in a direction along which the evaporation sources are arranged.

In a more preferable production method of the present invention, the material included in each of the plurality of evaporation sources is different from one another, and the material each contains at least one of a metal and a semimetal.

In a more preferable production method of the present invention, the materials are deposited on the resin substrate by a vacuum process method selected from a vapor deposition method, a sputtering method, and an ion plating method.

In another aspect of the present invention, an apparatus for producing a transparent gas barrier film including a plurality of thin films of two or more types having different components laminated in the thickness direction is provided.

The apparatus for producing a transparent gas barrier film including a transparent gas barrier layer in which a plurality of thin films having different components are laminated in the thickness direction, and the apparatus includes: a chamber having a thin film formation area and a non-formation area; a plurality of evaporation sources each including a material containing at least one of a metal and a semimetal; and a conveyor that feeds a long belt-shaped resin substrate, wherein the plurality of evaporation sources are disposed in the thin film formation area, the number of the evaporation sources being the same as the number of types of the thin films, the plurality of evaporation sources, independently of one another, include different materials, the plurality of evaporation sources are arranged side by side along a feeding direction of the long belt-shaped resin substrate or a direction orthogonally crossing the feeding direction, and the conveyor is configured to feed the resin substrate so as to cause the resin substrate to pass through the thin film formation area and the non-formation area alternately.

In a preferable production apparatus of the present invention, the conveyor is configured to feed the long belt-shaped resin substrate so as to draw a helical conveyance track.

In a more preferable production apparatus of the present invention, the plurality of evaporation sources are arranged side by side along the feeding direction of the long belt-shaped resin substrate.

In a more preferable production apparatus of the present invention, the apparatus further include a plasma source that generates a plasma; and a reaction gas supply device that supplies a reaction gas, in the chamber.

By using the production method and the production apparatus of the present invention, a transparent gas barrier film excellent in a gas barrier property is efficiently produced.

In addition, by using a preferable production method and a production apparatus of the present invention, a transparent gas barrier film having an excellent gas barrier property and very low internal stress in a transparent gas barrier layer can be efficiently produced.

### BRIEF DESCRIPTION OF DRAWINGS

Fig. 1 is a plan view illustrating a transparent gas barrier film according to one embodiment of the present invention.
Fig. 2 is an enlarged sectional view taken along the line II-II in Fig. 1.
Fig. 3 is an enlarged sectional view illustrating a transparent gas barrier film according to another embodiment.
Fig. 4 is an enlarged sectional view illustrating a transparent gas barrier film according to still another embodiment.
Fig. 5 is a front view illustrating an outline of an apparatus for producing a transparent gas barrier film according to a first embodiment.
Fig. 6 is a left side view of the production apparatus.
Fig. 7 is a schematic view illustrating for a reference of a process of forming thin films of two or more types.
Fig. 8 is a front view illustrating an outline of a modification of a production apparatus according to the first embodiment.
Fig. 9 is a front view illustrating an outline of a production apparatus according to the second embodiment.
Fig. 10 is a left side view of the production apparatus.
Fig. 11 is a front view illustrating an outline of a modification of a production apparatus according to a second embodiment.
Fig. 12 is a left side view of the production apparatus.

### DETAILED DESCRIPTION OF THE INVENTION

Hereinafter, the present invention will be described with reference to the drawings. It should be noted that dimensions such as a layer thickness and a length in the drawings are different from actual dimensions.

In this specification, as prefixes of the terms "first" and "second" may be added. These prefixes, however, are only added in order to distinguish the terms and do not have specific meaning such as order and relative merits. The "long belt-shape" means a substantially rectangular shape in which a length in one direction is sufficiently larger than a length in the other direction. For example, the "long belt-shape" is a substantially rectangular shape in which a length in one direction is 10 times or more, preferably 30 times or more, more preferably 100 times or more of a length in the other direction. The "long direction" is one direction of the long belt-shape (direction parallel to the longer side of the long belt-shape), and the "short direction" is the other direction of the long belt-shape (direction parallel to the shorter side of the long belt-shape). The wording "PPP to QQQ" means "PPP or more and QQQ or less".

### [Transparent Gas Barrier Film]

A transparent gas barrier film obtained by the production method and the production apparatus according to the present invention includes a resin substrate and a transparent gas barrier layer laminated on the resin substrate.

The transparent gas barrier layer includes a plurality of thin films of two or more types having different components. Among the plurality of thin films, at least two thin films are formed of different materials.

Hereinafter, when it is necessary to distinguish thin films of two or more types having different components, the term thereof may be preceded by the term "first", "second" or the like. For example, a thin film of one type having a certain component is referred to as a "first thin film", a thin film of one type having a component different from the component of the above thin film (first thin film) is referred to as a "second thin film", and a thin film of one type having a component different from the components of the first thin film and the second thin film is referred to as a "third thin film".

Each of the thin films contains at least one of a metal and a semimetal. The at least one of the metal and the semimetal is preferably at least one selected from the group consisting of an oxide, a nitride, a carbide, a nitride oxide, a carbide oxide, a carbide nitride, and a carbide nitride oxide. Examples of the metal include aluminum, titanium, indium, and magnesium. Examples of the semimetal include silicon, bismuth, and germanium. Carbon and nitrogen that densify a network structure (mesh-like structure) in a transparent gas barrier layer is preferably contained for improving the gas barrier property. Oxygen is preferably contained for further improving transparency. The component of the thin film particularly preferably contains at least one of a metal and a semimetal, and all of carbon, oxygen, and nitrogen. Such a component is typically a carbide nitride oxide of a metal or a semimetal.

Among a plurality of thin films that form the transparent gas barrier layer of the transparent gas barrier film of the present invention, at least two, preferably two or three thin films contain at least one of a metal and a semimetal, but the components of these thin films are mutually different.

Examples of thin films having different components include (A) a thin film of one type being composed of an oxide of a metal and a thin film of another type being composed of an oxide of a semimetal; (B) a thin film of one type being composed of a carbide nitride oxide of a metal and a thin film of another type being composed of a carbide nitride oxide of a semimetal; (C) a thin film of one type being composed of an oxide of a metal and a thin film of another type being composed of a nitride of a metal; and (D) a thin film of one type being composed of an oxide of a metal, a thin film of another type being composed of an oxide of a semimetal, and a thin film of still another type being composed of a carbide nitride oxide of a metal.

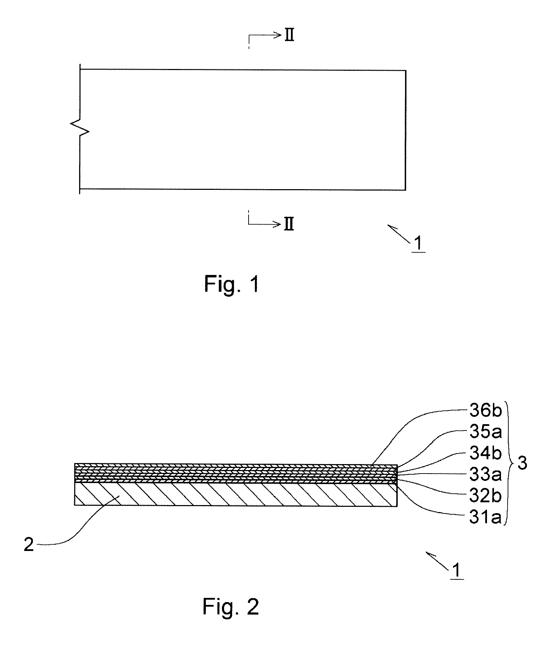

Fig. 1 is a plan view of a transparent gas barrier film according to one embodiment, and Fig. 2 is an enlarged sectional view obtained by cutting the film in the thickness direction.

A transparent gas barrier film 1 includes a transparent gas barrier layer 3 on a resin substrate 2. The transparent gas barrier layer 3 includes first and second thin films 31a, 32b, 33a, 34b, 35a, and 36b in order. In the transparent gas barrier film 1 in this illustrated example, thin films of two or more types (e.g. two types) having different components are alternately laminated. For example, the phrase "thin films of two types are alternately laminated" means that a plurality of laminated units each including a thin film of one type and a thin film of one type having a component different from that of the foregoing thin film are repeatedly laminated.

Specifically, all the first thin films 31a, 33a, and 35a have the same component, and all the second thin films 32b, 34b, and 36b have the same component. The component of the first thin films 31a, 33a, and 35a and the component of the second thin films 32b, 34b, and 36b are mutually different. Therefore, the transparent gas barrier layer 3 has a laminated structure in which a plurality of thin films (six thin films in this case) of two types having different components are alternately laminated.

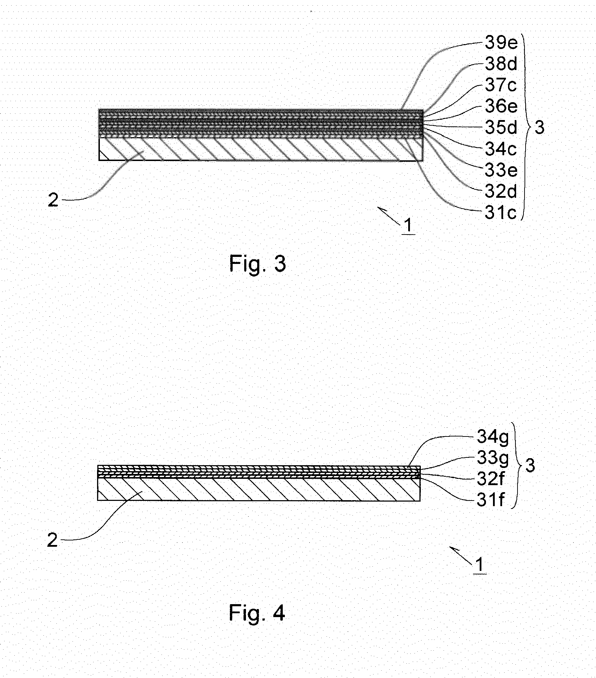

Fig. 3 is an enlarged sectional view of a transparent gas barrier film according to another embodiment (an enlarged sectional view obtained by cutting a transparent gas barrier film according to another embodiment at a location similar to the line II-II in Fig. 1).

In Fig. 3, the transparent gas barrier layer 3 provided on the resin substrate 2 includes first, second, and third thin films 31c, 32d, 33e, 34c, 35d, 36e, 37c, 38d, and 39e in order. In the transparent gas barrier film 1 in this illustrated example, thin films of two or more types (e.g. three types) having different components are alternately laminated. For example, the phrase "thin films of three types are alternately laminated" means that a plurality of laminated units each including a thin film of one type, a thin film of one type having a component different from that of the foregoing thin film, and a thin film of one type having a component different from those of foregoing two thin films are repeatedly laminated.

Specifically, all the first thin films 31c, 34c, and 37c have the same component, all the second thin films 32d, 35d, and 38d have the same component, and all the third thin films 33e, 36e, and 39e have the same component. The component of the first thin films 31c, 34c, and 37c, the component of the second thin films 32d, 35d, and 38d, and the component of the third thin films 33e, 36e, and 39e are mutually different. Therefore, the transparent gas barrier layer 3 has a laminated structure in which a plurality of thin films (nine thin films in this case) of three types having different components are alternately laminated.

Further, Fig. 4 is an enlarged sectional view of a transparent gas barrier film according to another embodiment (an enlarged sectional view obtained by cutting a transparent gas barrier film according to another embodiment at a location similar to the line II-II in Fig. 1).

In Fig. 4, the transparent gas barrier layer 3 provided on the resin substrate 2 includes first and second thin films 31f, 32f, 33g, and 34g in order. The transparent gas barrier film 1 in this illustrated example includes thin films of two or more types (e.g. two types) having different components, and thin films having the same component are continuously laminated. For example, the phrase "the film includes thin films of two types and thin films having the same component are continuously laminated" means that a first laminated unit and a second laminated unit are laminated, with the first laminated unit having a plurality of laminated thin films of one type and the second laminated unit having a plurality of laminated thin films of one type having a component different from that of the foregoing thin films.

Specifically, the first thin films 31f and 32f have the same component, and the second thin films 33g and 34g have the same component. The component of the first thin films 31f and 32f and the component of the second thin films 33g and 34g are mutually different. Therefore, the transparent gas barrier layer 3 has a laminated structure in which a plurality of thin films (two thin films in this case) of two types having different components has layers of the same type and these layers are continuously laminated.

The illustrated example shows thin films of two or three types having different components as types of thin films, but the number of types of thin films is not limited thereto as long as the number of types of thin films is two or more. For example, according to the production method and production apparatus of the present invention, a plurality of thin films of four or more types can also be formed.

Three thin films having the same component are laminated in the examples illustrated in Fig. 2 and Fig. 3, and two thin films having the same component are laminated in the example illustrated in Fig. 4, but the number of thin films having the same component is not limited thereto as long as the number of thin films having the same component is two or more. For example, according to the production method and the production apparatus of the present invention, four or more thin films having the same component can also be formed.

In view of a gas barrier property, transparency, a film formation time, and internal stress of the film, the thickness of the transparent gas barrier layer is preferably 1 µm or less, more preferably in a range of 100 nm to 800 nm, further preferably in a range of 200 nm to 500 nm. The thicknesses of the thin films are, independently of one another, preferably in a range of 50 nm to 200 nm, more preferably in a range of 10 nm to 100 nm. The thicknesses of the thin films may be the same, or independently different of one another, but preferably, the thin films having the same components are formed in the same thickness, and more preferably, the thickness of all of the thin films are formed in the same thickness.

The total number of the thin films is preferably in a range of 4 layers to 20 layers, more preferably in a range of 6 layers to 16 layers.

The resin substrate is flexible. The flexible resin substrate is a flexible sheet-shaped article which can be wound around a roll. For the resin substrate, a transparent resin substrate is used.

As the resin substrate, it is preferred to use a substrate having high heat resistance, particularly a substrate which has a high Tg (glass transition temperature) and is hard to be thermally shrunk in consideration of influences of heating by radiant heat from a plasma or an evaporation source. When a substrate which has a low Tg or is easily thermally shrunk is used, distortion may occur in the substrate at the time of forming a transparent gas barrier layer, so that cracks etc. are generated in the transparent gas barrier layer, leading to deterioration of the gas barrier property. Thus, it is preferred to use a transparent film having high heat resistance as the resin substrate. For example, the resin film is preferably a resin film having a shrinkage factor of 0.5% or lower in both a short direction (TD) and a long direction (MD).

Specific examples of the resin film include transparent films composed of cycloolefin polymers, polyethylene naphthalate, polyethylene sulfide, polyphenyl sulfide, polycarbonate, polyimide, polyamide, and the like.

The thickness of the resin substrate is preferably 20 µm to 200 µm, particularly preferably 50 µm to 150 µm from the viewpoint of handling.

The width of the resin substrate is not particularly limited, but is preferably 50 mm or less, for example.

The resin substrate may be subjected to a surface modifying treatment such as a corona discharge treatment, a plasma discharge treatment, or an ion etching (RIE) treatment on a surface thereof (a surface to be provided with a transparent gas barrier layer). Alternatively, the surface of the resin substrate may be provided with an inorganic substance layer or a polymer layer as a smooth layer and an adhesive layer.

### [Applications of Transparent Gas Barrier Film]

A transparent gas barrier film obtained by the production method and production apparatus of the present invention can be used for various applications. Particularly, the transparent gas barrier film of the present invention has an excellent gas barrier property and good flexibility, and therefore can be suitably used as a constituent member of various kinds of electronic devices. For example, the transparent gas barrier film of the present invention can be used for a support substrate or a sealing member of an organic EL element; a coating film of a solar cell; a coating film of a thin film battery; and so on.

For example, the organic EL element is composed of a laminate having a support substrate, an anodic layer provided on the support layer, an organic EL (electroluminescence) layer provided on the anodic layer, and a cathodic layer provided on the organic EL layer. A sealing member is provided on the laminate (on a cathodic layer). A transparent gas barrier film of the present invention can be used as at least one of the support substrate and the sealing member.

Examples of the anodic layer include transparent electrode layers such as ITO (Indium Tin Oxide) and IZO (registered trademark; Indium Zinc Oxide). The organic EL layer is composed of, for example, a positive hole injection layer, a positive hole transport layer, a light-emitting layer, an electron transport layer, and an electron injection layer. Examples of the cathodic layer include an aluminum layer, a magnesium/aluminum layer, and a magnesium/silver layer.

The sealing member may have a monolayer structure, or a multi-layer structure. When the sealing member has a multi-layer structure, the transparent gas barrier film of the present invention is used for at least one layer thereof.

When the transparent gas barrier film of the present invention is used as a sealing member, an organic EL element having an excellent gas barrier property can be formed by fixing the transparent gas barrier film to the laminate using fixation means such as an adhesive or heat seal.

When the transparent gas barrier film of the present invention is used as a support substrate of the organic EL element, the organic EL element can be made lighter, thinner and more flexible.

The organic EL element using the transparent gas barrier film of the present invention as a support substrate serves as a flexible display, and can be used in the form of an electronic paper when rolled, for example. When the transparent gas barrier film of the present invention is used as a sealing member, an organic EL layer is easily sealed, and a thin organic EL element can be obtained.

For example, the solar cell includes a solar battery cell, and the solar battery cell is coated with the transparent gas barrier film of the present invention. Particularly, the transparent gas barrier film can also be suitably used as a light-receiving-side front sheet and a protecting back sheet of a solar cell. One example of the structure of the solar cell is a structure in which a solar battery cell formed of a silicon thin film or a CIGS (Copper Indium Gallium DiSelenide) thin film is sealed with a resin of an ethylene-vinyl acetate copolymer etc., and further caught by the transparent gas barrier film of the present invention. Sealing with the resin may be omitted to catch the solar battery cell directly by the transparent gas barrier film of the present invention.

For example, the thin film battery includes a laminate including a current-collecting layer, an anodic layer, a solid electrolyte layer, a cathodic layer, and a current-collecting layer in this order, and the laminate is coated with the transparent gas barrier film of the present invention. Examples of the thin film battery include thin film lithium ion batteries. Specifically, in the thin film battery, a current-collecting layer provided on a substrate and composed of a metal, an anodic layer composed of a metal inorganic film, a solid electrolyte layer, a cathodic layer, and a current-collecting layer composed of a metal are laminated in this order. The transparent gas barrier film of the present invention can also be used as a substrate of the thin film battery.

### [Regarding Production Method of Transparent Gas Barrier Film and Production Apparatus thereof]

The method for producing the transparent gas barrier film of the present invention is performed using a roll-to-roll method. The method includes a step of laminating a plurality of thin films of two or more types having different components on a long belt-shaped resin substrate in the course of feeding the resin substrate, wherein evaporation sources are disposed in a thin film formation area, the number of the evaporation sources being the same as the number of types of the thin films (that is, the number of evaporation sources may be identical to the number of types of thin films), and the long belt-shaped resin substrate is passed through the thin film formation area and a non-formation area alternately, and the materials included in the plurality of evaporation sources are each deposited on the resin substrate in the thin film formation area to form on the resin substrate a transparent gas barrier layer having the plurality of laminated thin films of two or more types.

As a method for depositing the material on the resin substrate, a vacuum process method is used. Examples of the vacuum process method include a vapor deposition method, a sputtering method, and an ion plating method. In the present invention, any of a vapor deposition method, a sputtering method, and an ion plating method may be used, but a vapor deposition method is preferably used.

Preferably, in the thin film formation area, the plurality of evaporation sources are arranged and the resin substrate is fed in a direction along which the evaporation sources are arranged.

Materials included in the plurality of evaporation sources are each a material for forming a thin film. The materials are different for each type of evaporation source. The materials include preferably at least one of a metals and a semimetal, more preferably at least one selected from the group consisting of an oxide, a nitride, a carbide, a nitride oxide, a carbide oxide, a carbide nitride, and a carbide nitride oxide of a metal or a semimetal.

The WVTR of a transparent gas barrier film obtained by the production method of the present invention is 0.01 g·m⁻²·day⁻¹ or less, preferably 0.001 g·m⁻²·day⁻¹ or less.

The production apparatus of the present invention is used for carrying out the production method.

That is, the production apparatus of the present invention is an apparatus that is applied for producing a transparent gas barrier film including a transparent gas barrier layer in which a plurality of thin films having different components are laminated in the thickness direction.

The production apparatus includes: a chamber having a thin film formation area and a non-formation area; evaporation sources each including a material containing at least one of a metal and a semimetal; and a conveyor that feeds a long belt-shaped resin substrate, wherein evaporation sources are disposed in the thin film formation area, the number of evaporation sources being the same as the number of types of the thin films, the plurality of evaporation sources, independently of one another, include different materials, the plurality of evaporation sources are arranged side by side along a feeding direction of the long belt-shaped resin substrate or a direction orthogonally crossing the feeding direction, and the conveyor is configured to feed the resin substrate so as to pass the resin substrate through the thin film formation area and the non-formation area alternately.

Hereinafter, a formation method of the thin film will be described in detail and the description will be focusing on the cases where a deposition method is used.

### [First Embodiment of Production Method and Production Apparatus of the Present Invention]

The production method and the production apparatus of the first embodiment is to produce a transparent gas barrier film in which a plurality of thin films having different components are alternately laminated on a long belt-shaped resin substrate.

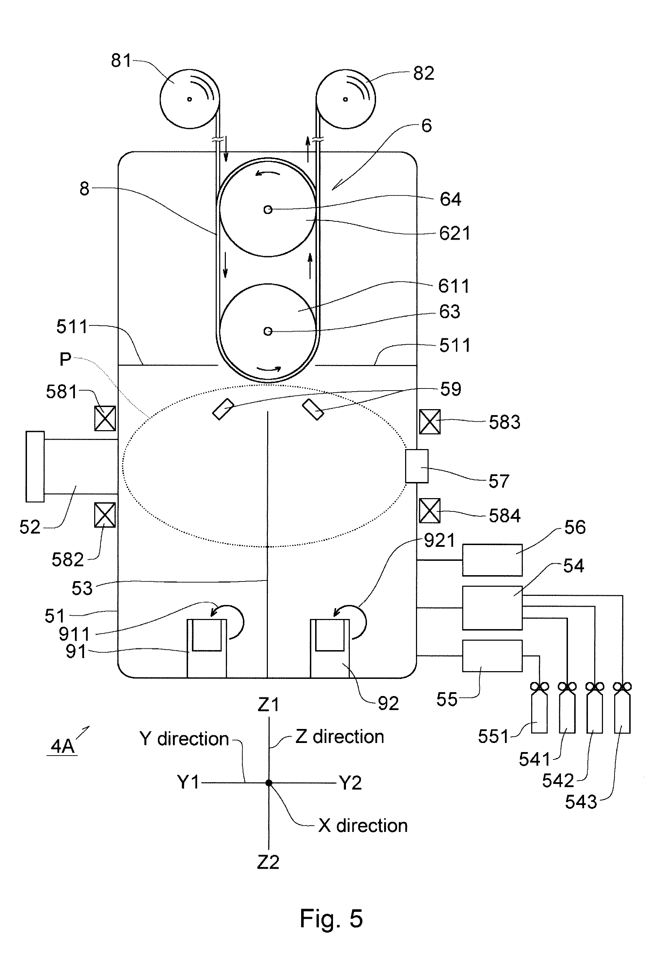

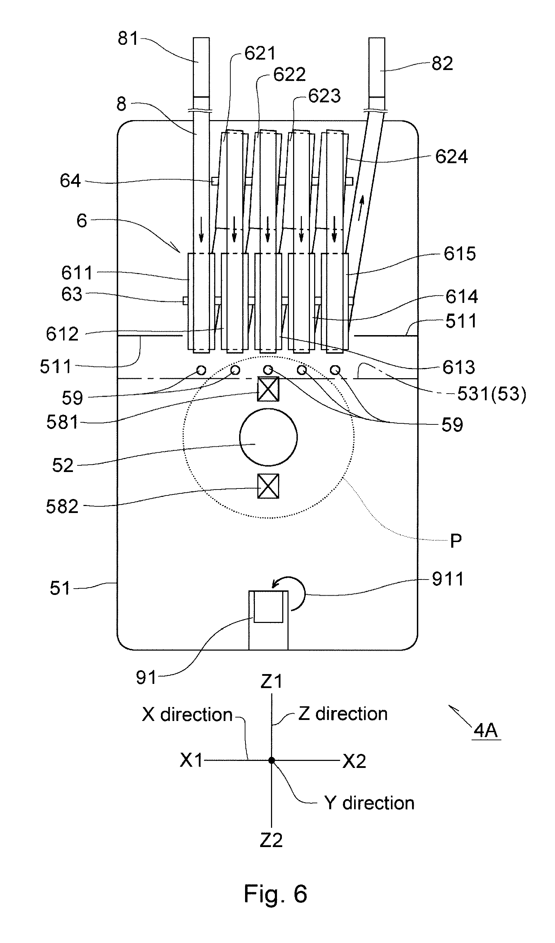

Figs. 5 and 6 illustrate an example of a configuration of the production apparatus of the first embodiment.

Hereinafter, in each drawing illustrating each production apparatus, a direction orthogonally crossing a horizontal plane is referred to as a "Z direction", a direction orthogonally crossing the Z direction is referred to as an "X direction", and a direction orthogonally crossing the Z direction and X direction is referred to as a "Y direction" for the sake of convenience. Further, one side in the X direction is referred to as an "X1 side" and the opposite side in the X direction (side opposite to the one side) is referred to as an "X2 side"; one side in the Y direction is referred to as a "Y1 side" and the opposite side in the Y direction (side opposite to the one side) is referred to as a "Y2 side"; and one side in the Z direction is referred to as a "Z1 side" and the opposite side in the Z direction (side opposite to the one side) is referred to as a "Z2 side".

Fig. 5 is a front view of the production apparatus seen from the X2 side in the X direction, and Fig. 6 is a left side view of the production apparatus seen from the Y1 side in the Y direction.

A production apparatus 4A includes a chamber 51, the inside of which can be held in vacuum; a conveyor 6 that continuously feeds a long belt-shaped resin substrate 8; a plasma source 52 that generates a plasma; a plurality of evaporation sources 91 and 92 that include material for film formation; a reaction gas supply device 54 that supplies a reaction gas into the chamber 51; a discharge gas supply device 55 that supplies a discharge gas into the chamber 51; and a vacuum pump 56 that brings the inside of the chamber 51 into a vacuum state. The film formation is performed by a deposition method, so the evaporation sources are deposition sources.

The principal part of the conveyor 6 is disposed in the chamber 51, and the plasma source 52 and the evaporation sources are disposed in the chamber 51.

In the chamber 51, a partition wall 511 that separates the thin film formation area and the non-formation area from each other is provided. The thin film formation area is one region in the chamber 51, at which a material can be deposited on an adherend (that is, the long belt-shaped resin substrate 8). The non-formation area is the other region in the chamber 51, at which a material is not deposited on an adherend. In the illustrated example, with the partition wall 511 as a reference, a region on the Z2 side (lower side) with respect to the partition wall 511 is the thin film formation area, and a region on the Z1 side (upper side) with respect to the partition wall 511 is the non-formation area.

Of course, it is not necessarily required to provide the partition wall 511, and it is also possible to omit the partition wall 511.

The plasma is not particularly limited, and for example, an arc discharge plasma, a glow discharge plasma, or the like may be used. An arc discharge plasma is preferably used because a very high electron density is achieved unlike a glow discharge plasma. By using an arc discharge plasma, reactivity of a material can be enhanced, so that a very dense transparent gas barrier layer can be formed on a resin substrate.

As an arc discharge plasma generation source (plasma source 52), for example, a pressure gradient type plasma gun, a direct-current discharge plasma generator, a high-frequency discharge plasma generator, or the like may be used. Among them, a pressure gradient type plasma gun is preferably used as the plasma source 52 because a high-density plasma can be stably generated during deposition.

In the illustrated example, a pressure gradient type plasma gun is used as the plasma source 52. The plasma source 52 is disposed in, for example, a first side wall (side wall on the Y1 side) of the chamber 51 as illustrated in Fig. 5. On a second side wall (side wall on the Y2 side opposite to the first side wall) of the chamber 51, a reflection electrode 57 is disposed to face the pressure gradient type plasma gun. Focusing electrodes 581, 582, 583, and 584 are disposed on the circumference of the plasma source 52 and the circumference of the reflection electrode 57. The plasma source 52 is controlled so that a plasma beam P is applied toward the reflection electrode 57, and the plasma beam P is formed into a necessary shape by the focusing electrodes 581, 582, 583, and 584.

Evaporation sources 91 and 92 are installed on the bottom of the chamber 51 so as to face the conveyor 6 (precisely, so as to face the resin substrate 8 at the time when the upper surfaces of evaporation sources 91 and 92 pass through the thin film formation area). A material for film formation is placed on the upper surface of each of evaporation sources 91 and 92.

In the illustrated example, two evaporation sources 91 and 92 are disposed. The number of evaporation sources 91 and 92 is identical to the number of types of thin films to be formed. Therefore, the production apparatus of this embodiment can alternately form thin films of two types having different components.

The two evaporation sources 91 and 92 (first evaporation source 91 and second evaporation source 92) are arranged side by side along a feeding direction of the resin substrate 8. In this embodiment, the resin substrate 8 is fed in the Y direction (from Y1 side to Y2 side) in the thin film formation area, and therefore the first and second evaporation sources 91 and 92 are arranged in the Y direction. For example, the first evaporation source 91 is disposed on the Y1 side with respect to a rotating shaft 63 of an inside guide roller 611, and the second evaporation source 92 is disposed on the Y2 side with respect to the rotating shaft 63. The positions of the first evaporation source 91 and the second evaporation source 92 in the X direction may be the same, or may be mutually shifted. The positions of the first evaporation source 91 and the second evaporation source 92 in the X direction are preferably the same. For example, the first evaporation source 91 and the second evaporation source 92 are disposed in correspondence with a substantially central part in the X direction of a plurality of inside guide rollers 611 as illustrated in Fig. 6.

The first evaporation source 91 includes a metal, a semimetal, and at least one selected from the group consisting of an oxide, a nitride, a carbide, a nitride oxide, a carbide oxide, a carbide nitride, and a carbide nitride oxide of the metal and the semimetal.

The second evaporation source 92 includes the material different from the material included in the first evaporation source 91 and includes at least one of a metal, a semimetal, and at least one selected from the group consisting of an oxide, a nitride, a carbide, a nitride oxide, a carbide oxide, a carbide nitride, and a carbide nitride oxide of the metal and the semimetal.

When the material is deposited in the presence of a reaction gas as in this embodiment, a thin film can be formed while a component of the reaction gas is introduced into the material in the evaporation source.

For example, when at least one selected from a metal and a semimetal is used as the above-mentioned material, the thin film composed of an oxide, a nitride, a carbide, a nitride oxide, a carbide oxide, a carbide nitride, or a carbide nitride oxide can also be formed by depositing the material with a plasma generated in the presence of a reaction gas. Of course, the foregoing oxide, nitride, carbide, nitride oxide, carbide oxide, carbide nitride, or carbide nitride oxide may be used as the material placed in each of the evaporation sources 91 and 92.

A partition wall 53 for separating the first evaporation source 91 and the second evaporation source 92 is erectly disposed in the thin film formation area. It is to be noted that in Fig. 6, an upper end edge 531 of the partition wall 53 is illustrated by a dashed line. The partition wall 53 is interposed between the first evaporation source 91 and the second evaporation source 92 so that a material vaporized from the first evaporation source 91 and a material vaporized from the second evaporation source 92 are not mixed together. By providing the partition wall 53, the thin film formation area of the chamber 51 is divided into a first room for storing the first evaporation source 91 and a second room for storing the second evaporation source 92. The partition wall 53 is a plate-shaped wall, and is disposed so that the wall surface includes a Z direction and an X direction. Both side edges of the partition wall 53 are fixed on the opposite side walls of the chamber 51. The lower end edge of the partition wall 53 is fixed on the bottom of the chamber 51, or disposed in the vicinity of the bottom of the chamber 51. The upper end edge 531 of the partition wall 53 is extended to the vicinity of the lower part of the inside guide roller 611.

The partition wall 53 is provided such that its upper end edge 531 is situated just below the rotating shaft 63 of the inside guide roller 611 as illustrated in the figure. Specifically, the upper end edge 531 of the partition wall 53 is disposed in the vicinity of the lower part of the inside guide roller 611 and on the Z direction extending through the rotating shaft 63. By disposing the partition wall 53 just below the rotating shaft 63, a material of the first evaporation source 91 and a material of the second evaporation source 92 can be substantially uniformly deposited on the resin substrate. That is, by disposing the partition wall 53 just below the rotating shaft 63, a thin film obtained by depositing a material of the first evaporation source 91 and a thin film obtained by depositing a material of the second evaporation source 92 can be formed with substantially the same thickness.

Of course, the partition wall 53 is not necessarily provided just below the rotating shaft 63, and may be provided at a position shifted from the rotating shaft 63, for example a position on the Y1 side or the Y2 side with respect to the rotating shaft 63.

As means for evaporating the material in each of the evaporation sources 91 and 92, the plasma may be used, but resistance heating or an electron beam may also be used.

The reaction gas supply device 54 is disposed on, for example, the second side wall of the chamber 51. Reaction gas storage cylinders 541, 542, and 543 are connected to the reaction gas supply device 54 and the number of the reaction gas storage cylinders is the same as the number of reaction gases.

Examples of the reaction gas include oxygen-containing gas, nitrogen-containing gas, hydrocarbon-containing gas, and mixture of these gases. Examples of the oxygen-containing gas include oxygen (O₂), dinitrogen monoxide (N₂O), and nitric oxide (NO), examples of nitrogen-containing gas include nitrogen (N₂), anmonia (NH₃), and nitric oxide (NO), and examples of hydrocarbon-containing gas include methane (CH₄), ethane (C₂H₆), propane (C₃H₈), butane (C₄H₁₀), ethylene (C₂H₄), and acethylene (C₂H₂).

The discharge gas supply device 55 is disposed on, for example, the second side wall of the chamber 51. A discharge gas storage cylinder 551 is connected to the discharge gas supply device 55, and the discharge gas supply device 55 supplies a discharge gas at an appropriate pressure into the chamber 51. As the discharge gas, typically an inert gas such as an argon gas may be used.

The vacuum pump 56 is disposed on, for example, the second side wall of the chamber 51. By actuating the vacuum pump 56, the inside of the chamber 51 can be evacuated into a vacuum state.

The conveyor 6 conveys the long belt-shaped resin substrate 8 in its long direction by so called a roll-to-roll method.

The conveyor 6 has a plurality of guide rollers 611 and 621 for feeding the long belt-shaped resin substrate 8 in the long direction. Some of the plurality of guide rollers are disposed in the thin film formation area for guiding the resin substrate 8 to the thin film formation area.

In this embodiment, the conveyor 6 feeds the long belt-shaped resin substrate 8 so as to draw a helical conveyance track, and guides the resin substrate 8 to a film formation area and a non-formation area alternately.

As such a conveyor 6 that performs helical conveyance, for example, an apparatus disclosed in Japanese Patent No. 4472962 can be used.

The conveyor 6 has a basic configuration in which there are a plurality of pairs of guide rollers 611 and 621 that can be rotated so as to feed the long belt-shaped resin substrate 8 in its long direction as illustrated in Figs. 5 and 6.

Of the pair of guide rollers, one is disposed in the thin film formation area and the other is disposed in the non-formation area. Hereinafter, the guide roller disposed in the thin film formation area is referred to as an "inside guide roller" and the guide roller disposed in the non-formation area is referred to as an "outside guide roller" for the sake of convenience, and prefixes of "first", "second" and so on are added for distinguishing a plurality of guide rollers.

The production apparatus 4A in the illustrated example is an apparatus capable of laminating first to tenth thin films on the resin substrate 8. In the conveyor 6, inside guide rollers are disposed in the thin film formation area (first to fifth inside guide rollers 611, 612, 613, 614, and 615) and the number of the inside guide rollers is the same as the number of times the resin substrate 8 passes through the thin film formation area so that the resin substrate 8 passes through the thin film formation area five times.

The inside guide rollers 611,... (first to fifth inside guide rollers 611 to 615) disposed in the thin film formation area may be wholly included within the thin film formation area, or may be disposed so as to be partially included within the thin film formation area as illustrated in the figure.

On the other hand, the outside guide rollers 621,... are disposed on the Z1 side with respect to the inside guide rollers 611, and the number thereof is smaller by 1 than the number of the inside guide rollers 611.

For the first to fifth inside guide rollers 611 to 615, for example, rollers having the same diameter and width can be used. For the first to fourth outside guide rollers 621, 622, 623, and 624, for example, rollers having the same diameter and width can be used.

The first to fifth inside guide rollers 611 to 615 are rotatably attached to a rotating shaft 63, and the first to fourth outside guide rollers 621 to 624 are rotatably attached to a rotating shaft 64. Directions along which the rotating shafts 63 and 64 extend (axis direction) are both parallel to the X direction.

The first to fifth inside guide rollers 611 to 615 are arranged side by side at necessary intervals on the rotating shaft 63, and the first to fourth outside guide rollers 621 to 624 are similarly arranged side by side at necessary intervals on the rotating shaft 64. The interval between adjacent inside guide rollers 611 is preferably as small as possible because the apparatus can be made smaller.

The first to fourth outside guide rollers 621 to 624 are rotatably attached to the rotating shaft 64 while being slightly inclined with respect to the rotating shaft 64 for helically feeding the resin substrate 8 to each guide roller.

Two crystal monitors 59 and 59 are provided in the vicinity of the first to fifth inside rollers 611 to 615. The crystal monitors 59 and 59 are for measuring and controlling the deposition rate of the material of the first to second evaporation sources 91 and 92. The crystal monitor 59 on one hand is disposed on the first evaporation source 91 side and in the vicinity of the lower part of each of the first to fifth inside guide rollers 611 to 615, and the crystal monitor 59 on the other hand is disposed on the second evaporation source 92 side and in the vicinity of the lower part of each of the first to fifth inside guide rollers 611 to 615.

A temperature controller (not illustrated) may be attached to the first to fifth inside guide rollers 611 to 615 as necessary. The temperature controller is provided for adjusting the surface temperature of the inside guide roller 611. Examples of the temperature controller include a heat medium circulation device for circulating silicone oil etc.

The long belt-shaped resin substrate 8 drawn out from the roll 81 on the upstream side is fed from the Z1 side to the Z2 side, wound around the lower circumferential surface of the first inside guide roller 611, then fed from the Z2 side to the Z1 side, and wound around the upper circumferential surface of the first outside guide roller 621. When the resin substrate 8 is passing over the lower circumferential surface of the first inside guide roller 611, the resin substrate 8 is fed from the Y1 side to the Y2 side (in Y direction). When the resin substrate 8 is passing over the upper circumferential surface of the first outside guide roller 621, the resin substrate 8 is fed from the Y2 side to the Y1 side (in Y direction).

The long belt-shaped resin substrate 8 is wound around the upper circumferential surface of the first outside guide roller 621, then similarly wound around the second inside guide roller 612, the second outside guide roller 622, the third inside guide roller 613, the third outside guide roller 623, the fourth inside guide roller 614, the fourth outside guide roller 624, and the fifth inside guide roller 615 in this order, then fed from the Z2 side to the Z1 side, and wound around the roll 82 on the downstream side.

Therefore, the resin substrate 8 is fed while drawing a helical track clockwise as a whole as seen from the X1 side. That is, the resin substrate 8 is helically fed through a plurality of the inside guide rollers 611,... and the outside guide rollers 621,... disposed in the thin film formation area and the non-formation area as described above. Accordingly, the conveyor 6 is configured to feed the resin substrate 8 while passing the resin substrate 8 through the thin film formation area and the non-formation area alternately.

However, when the resin substrate 8 passes through the thin film formation area, the resin substrate 8 is fed in the Y direction (from the Y1 side to the Y2 side) as illustrated in Fig. 5. In the production apparatus 4A of this embodiment in which the plasma source 52 is disposed on the Y1 side, the resin substrate 8 is fed so as to go away from the plasma source 52 at the time of passing the resin substrate 8 through the thin film formation area.

A method for producing a transparent gas barrier film will now be described. Hereinafter, a method for producing a transparent gas barrier film using the production apparatus 4A illustrated in Figs. 5 and 6 will be described, but the production method of the present invention is not limited to production using the production apparatus 4A.

By actuating the vacuum pump 56, the inside of the chamber 51 is kept in a vacuum state. The pressure of the inside of the chamber 51 in formation of a thin film layer on the resin substrate 8 falls within a range of 0.01 Pa to 0.1 Pa, preferably 0.02 Pa to 0.05 Pa.

In the thin film formation area in the chamber 51, a discharge gas is introduced from the discharge gas supply device 55 into a pressure gradient type plasma gun as the arc discharge plasma generation source 52, and a constant voltage is applied to apply a plasma toward the reflection electrode 57. The shape of the plasma beam P is controlled to necessary shape by the focusing electrodes 581, 582, 583, and 584. The power of the arc discharge plasma is, for example, 1 to 10 kW. A reaction gas is introduced into the chamber 51 from the reaction gas supply device 54. A material placed in each of the evaporation sources 91 and 92 is irradiated with, for example, electron beams 911 and 921 to evaporate the material toward the resin substrate 8.

Introduction of the reaction gas and generation of the plasma may be performed in parallel, or the plasma may be generated after introduction of the reaction gas, or the reaction gas may be introduced after generation of the plasma. The reaction gas is only required to exist in the thin film formation area during formation of a transparent gas barrier layer.

Preferably, an opening/closing shutter (not illustrated) is disposed between the evaporation source and the resin substrate 8 beforehand, the shutter is closed after the start of evaporation of the material until the deposition rate is stabilized, and after the deposition rate is stabilized, the shutter is opened to deposit the material on the resin substrate 8.

The deposition rate of the material in the evaporation sources 91 and 92 can be appropriately set, and is, for example, 10 to 300 nm/minute.

On the other hand, the long belt-shaped resin substrate 8 is drawn out from the roll 81 on the upstream side, and introduced into the chamber 51. In the illustrated example, rolls 81 and 82 are disposed outside the chamber 51, but may be disposed on the non-formation area in the chamber 51.

The length of the long belt-shaped resin substrate 8 in the short direction is not particularly limited, and it can be appropriately set, and is, for example, several mm to 1000 mm.

For example, when a transparent gas barrier film to be used as a support substrate of an organic EL element is produced, the length of the long belt-shaped resin substrate 8 in the short direction is set to, for example, several mm to 100 mm, preferably 10 mm to about 40 mm.

The resin substrate 8 is wound around each of the guide rollers 611 and 621 of the conveyor 6, and the resin substrate 8 is fed so as to draw a helical track, and caused to pass through the thin film formation area and the non-formation area alternately.

The conveyance speed of the resin substrate 8 can be appropriately set in consideration of the deposition rate and the thickness of a thin film formed etc., and is, for example, 0.1 to 20 m/minute.

When the resin substrate 8 sequentially passes through the thin film formation area (i.e. when the resin substrate 8 passes over the lower parts of the first to fifth inside guide rollers 611 to 615), the material of evaporation sources 91 and 92 is sequentially deposited on the resin substrate 8, so that two types of the thin films are formed one after another.

For promoting deposition in the thin film formation area, the surface temperature of the resin substrate 8 is set to, for example, 20°C to 200°C, preferably 80°C to 150°C.

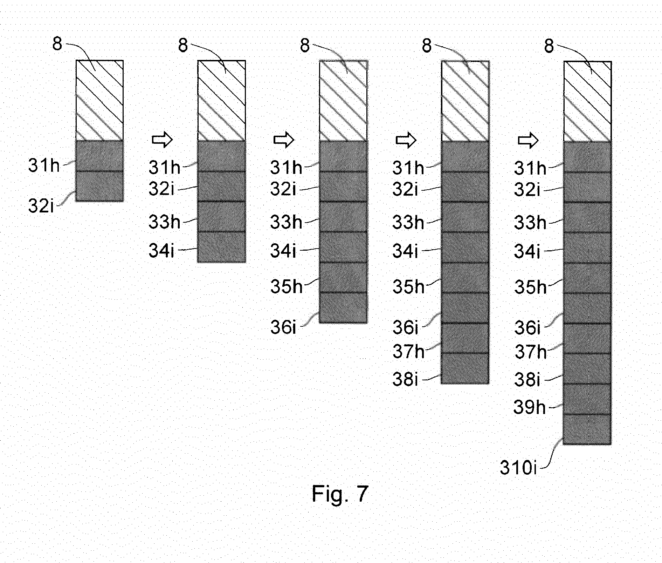

Specifically, as illustrated in Fig. 7, a first thin film 31h is formed on the surface of the resin substrate 8, and a second thin film 32i is subsequently formed.

The resin substrate 8 provided with the first thin film 31h and the second thin film 32i passes through the non-formation area by way of the circumferential surface of the first outside guide roller 621, and is then guided to the thin film formation area again by passing over the lower circumferential surface of the second inside guide roller 612. At this time, the material of the first evaporation source 91 is deposited on the surface of the second thin film 32i to form a first thin film 33h, and subsequently the material of the second evaporation source 92 is deposited on the surface of the first thin film 33h to form a second thin film 34i as illustrated in Fig. 7.

Thereafter, similarly a first thin film 35h and a second thin film 36i are formed on the surface of the second thin film 34i, a first thin film 37h and a second thin film 38i are formed on the surface of the second thin film 36i, and a first thin film 39h and a second thin film 310i are formed on the surface of the second thin film 38i as illustrated in Fig. 7 when the resin substrate passes through the thin film formation area from the non-formation area.

Accordingly, a transparent gas barrier layer, in which a plurality of thin films of two or more types (first and second thin films) having different components are alternately laminated repeatedly (five repetitions in the illustrated example), can be formed on the resin substrate 8.

The number of repetitions of the thin films of two or more types is identical to the number of times the resin substrate passes through the thin film formation area. When the production apparatus described as an example in this embodiment is used, the number of repetitions is identical to the number of the inside guide rollers.

According to the production apparatus and the production method of the present invention, a transparent gas barrier film can be efficiently produced because in the course of feeding a long belt-shaped resin substrate in the long direction, a transparent gas barrier layer having a plurality of laminated thin films of two or more types can be formed on the surface of the resin substrate. In the production apparatus and production method of the present invention, the number of evaporation sources used may be identical to the number of types of thin films formed. Therefore, installation costs of evaporation sources and control costs thereof become relatively low, so that a transparent gas barrier film can be relatively inexpensively produced.

Such a transparent gas barrier film has an excellent gas barrier property because thin films of two or more types are laminated.

### [Modification of First Embodiment]

In the first embodiment, a method and an apparatus for producing a transparent gas barrier film with thin films of two types formed alternately are described as an example, but a transparent gas barrier film with thin films of three or more types formed alternately can also be produced in the present invention.

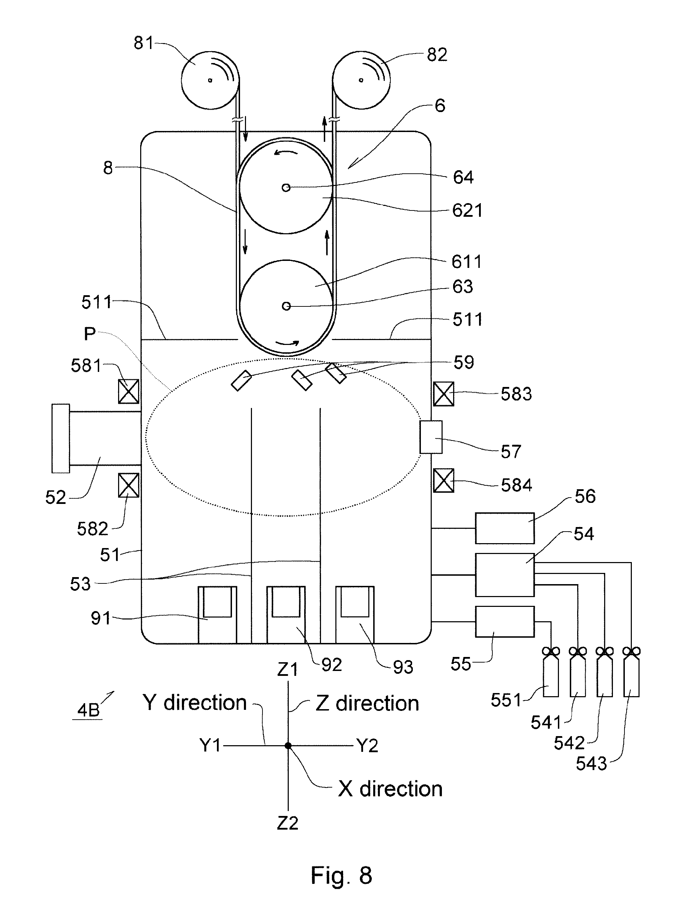

Fig. 8 is a front view of a production apparatus capable of alternately forming thin films of three types as seen from the X2 side in the X direction.

A production apparatus 4B is similar to that in the first embodiment except that three evaporation sources are disposed. In Fig. 8, configurations identical to those in the first embodiment are given the same symbol.

The three evaporation sources 91, 92, and 93 (first evaporation source 91, second evaporation source 92, and third evaporation source 93) of the production apparatus 4B are arranged side by side along a feeding direction of the resin substrate 8. For example, the first evaporation source 91 is disposed on the Y1 side with respect to a rotating shaft 63 of an inside guide roller 611, the second evaporation source 92 is disposed directly underneath of the rotating shaft 63, and the third evaporation source 93 is disposed on the Y2 side with respect to the rotating shaft 63. The positions of all the first evaporation source 91 to the third evaporation source 93 in the X direction are preferably the same. For example, the first evaporation source 91 to the third evaporation source 93 are all disposed in correspondence with a substantially central part in the X direction of a plurality of inside guide rollers 611.

The first evaporation source 91 includes a metal, a semimetal, and an oxide of the metal and the semimetal, the second evaporation source 92 includes a material different from the first evaporation source 91, and the third evaporation source 93 includes a material different from the first evaporation source 91 and the second evaporation source 92.

Furthermore, similarly to the first embodiment, the partition walls 53 and 53 are disposed for separating the first evaporation source 91 and the second evaporation source 92, and the second evaporation source 92 and the third evaporation source 93, respectively.

The production apparatus 4B according to the modification can be operated in the same manner as in the first embodiment. According to the production method and the production apparatus according to the modification, when the resin substrate passes through the thin film formation area, a material of the first evaporation source 91 is deposited to form a first thin film, a material of the second evaporation source 92 is subsequently deposited on the surface of the first thin film to form a second thin film, and a material of the third evaporation source 93 is subsequently deposited on the surface of the second thin film to form a third thin film. When the resin substrate provided with the first to third thin films passes through the thin film formation area again from the non-formation area, first to third thin films are formed. In this manner, a transparent gas barrier film can be formed in which a plurality of thin films of two or more types (first, second and third thin films) having different components are alternately laminated repeatedly as illustrated in Fig. 3.

When a transparent gas barrier film in which thin films of four types having different components are alternately laminated is produced, similarly four evaporation sources are disposed, and when thin films of five or more types are formed, five or more evaporation sources are disposed.

In the production method and the production apparatus in the first embodiment, the resin substrate is caused to pass through the thin film formation area five times, but the number of times is not particularly limited as long as the number of times is two or more. For example, when the resin substrate is caused to pass through the thin film formation area three times, a transparent gas barrier film can be formed in which a laminated unit including thin films of two or more types is repeatedly laminated three times. In order to allow the resin substrate to pass through the thin film formation area three times, for example, three inside guide rollers as described above are used.

In the first embodiment, a plurality of the inside guide rollers 611 having the same diameter are used, but rollers having different diameters (not illustrated) may also be used for some of the inside guide rollers. By way of an example, guide rollers having a small diameter are used as the first to third inside guide rollers 611, 612, and 613, and guide rollers having a large diameter are used as the fourth to fifth inside guide rollers 614 and 615. In this case, comparison between passage of the resin substrate over the lower circumferential surface of the inside guide roller having a large diameter and passage of the resin substrate over the lower circumferential surface of the inside guide roller having a small diameter shows that when passing over the lower circumferential surface of the inside guide roller having a large diameter, the resin substrate 8 passes through the thin film formation area over a long time, so that a thin film having a large thickness can be formed.

In the first embodiment, the conveyor having a pair of upper and lower guide rollers (inside guide roller and outside guide roller) as a conveyor is used, but a conveyor capable of helically feeding a resin substrate with one roller can be used

### [Second Embodiment of Production Method and Production Apparatus of the Present Invention]

The production method and the production apparatus of the second embodiment are intended to produce a transparent gas barrier film in which the transparent gas barrier film includes thin films of two or more types having different components on a long belt-shaped resin substrate and thin films having the same component are continuously laminated.

Hereinafter, the second embodiment will be described, but descriptions of configurations and effects similar to those in the first embodiment are omitted assuming that they have been already described, and the same terms and symbols are applied.

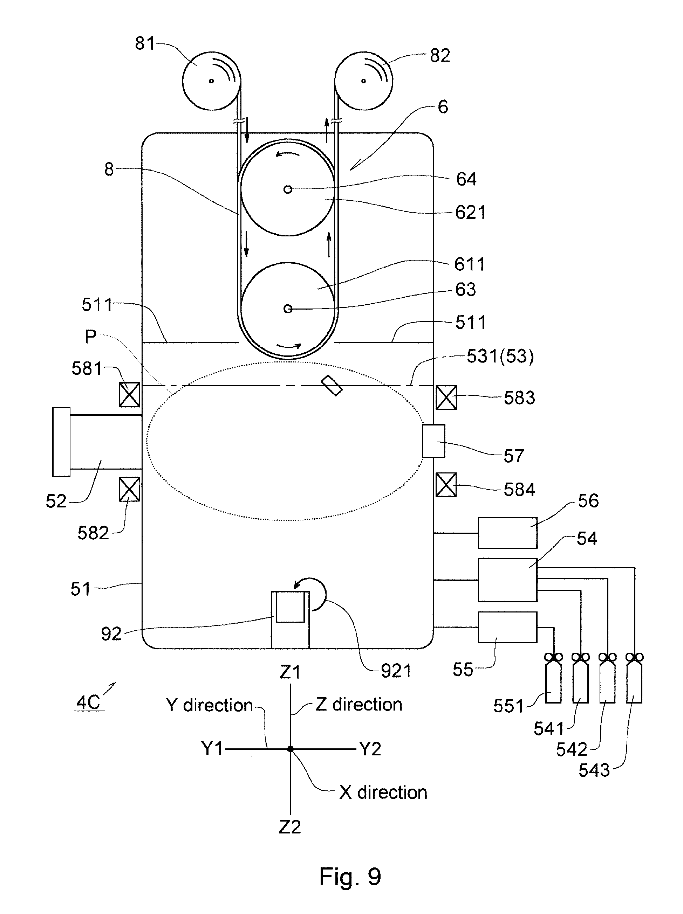

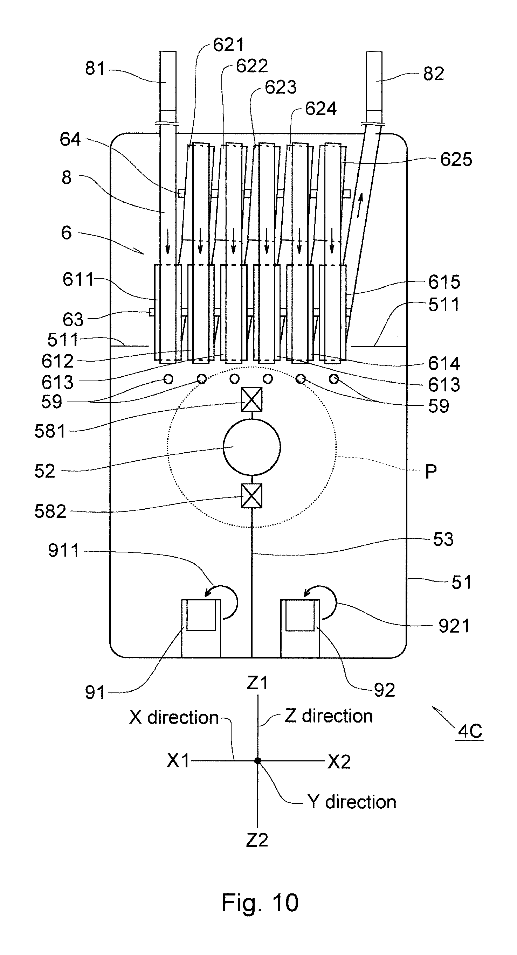

Fig. 9 is a front view of the production apparatus of the second embodiment seen from the X2 side in the X direction, and Fig. 10 is a left side view of the production apparatus seen from the Y1 side in the Y direction.

Similarly to the first embodiment, the production apparatus 4C includes a chamber 51, a conveyor 6 that feeds the long belt-shaped resin substrate 8 so as to draw a helical track, a plasma source 52, a reflection electrode 57, focusing electrodes 581, 582, 583, and 584, an evaporation source, a reaction gas supply device 54, a discharge gas supply device 55, and a vacuum pump 56.

The conveyor 6 of this embodiment has the first to sixth inside guide rollers 611, 612, 613, 614, 615, and 616, and the first to fifth outside guide rollers 621, 622, 623, 624, and 625 so that the resin substrate 8 can pass through the thin film formation area six times.

Two evaporation areas are disposed, for example.

First and second evaporation sources 91 and 92 are installed on the bottom of the chamber 51 so as to face the conveyor 6 (precisely, so as to face the resin substrate 8 at the time when the upper surfaces of evaporation sources 91 and 92 pass through the thin film formation area).

The first evaporation source 91 and the second evaporation source 92 are arranged side by side in the direction orthogonally crossing a feeding direction of the resin substrate 8. In this embodiment, the resin substrate 8 is fed in the Y direction (from Y1 side to Y2 side) in the thin film formation area, and therefore the first and second evaporation sources 91 and 92 are arranged in the X direction. For example, the first evaporation source 91 is disposed on the X1 side with respect to a substantially central part in the X direction of a plurality of inside guide rollers 611, and the second evaporation source 92 is disposed on the X2 side. The positions of the first evaporation source 91 and the second evaporation source 92 in the Y direction may be the same, or may be mutually shifted, but are preferably the same.

The first evaporation source 91 and the second evaporation source 92 include different materials.

The partition wall 53 is interposed between the first evaporation source 91 and the second evaporation source 92. In the case of embodiments, the partition wall 53 is disposed so that the wall surface includes a Z direction and a Y direction.

A method for producing a transparent gas barrier film will now be described.

The production apparatus 4C of this embodiment is operated, and when a resin substrate 8 passes through a thin film formation area by way of the circumferential surface of a first inside guide roller 611, a material of the first evaporation source 91 is deposited on the surface of the resin substrate 8 to form a first thin film.

The resin substrate 8 provided with the first thin film passes through the non-formation area by way of the circumferential surface of the first outside guide roller 621, and is then guided to the thin film formation area again by passing over the lower circumferential surface of the second inside guide roller 612. At this time, the material of the first evaporation source is deposited on the surface of the first thin film again, and a second layer of the first thin film is formed. Similarly, when the resin substrate 8 passes through the lower circumferential surface of a third inside guide roller 613, a third layer of the first thin film is formed on the surface of the second layer of the first thin film.

Subsequently, when the resin substrate 8 passes through the lower circumferential surface of a fourth inside guide roller 614, a first layer of a second thin film is formed on the surface of the third layer of the first thin film, and thereafter, similarly a second layer of the second thin film is formed on the surface of the first layer of the second thin film, and a third layer of the second thin layer is formed on the surface of the second layer of the second thin film.

According to this embodiment, a transparent gas barrier layer in which a plurality of thin films of two or more types (first and second thin films) having different components can be formed on the resin substrate 8.

### [Modification of Second Embodiment]

In the second embodiment, a case of conveying a long belt-shaped resin substrate so as to draw a helical conveyance track is described as an example, but the transparent gas barrier film can also be produced while a long belt-shaped resin substrate is fed so as to draw, for example, a meandering conveyance track.

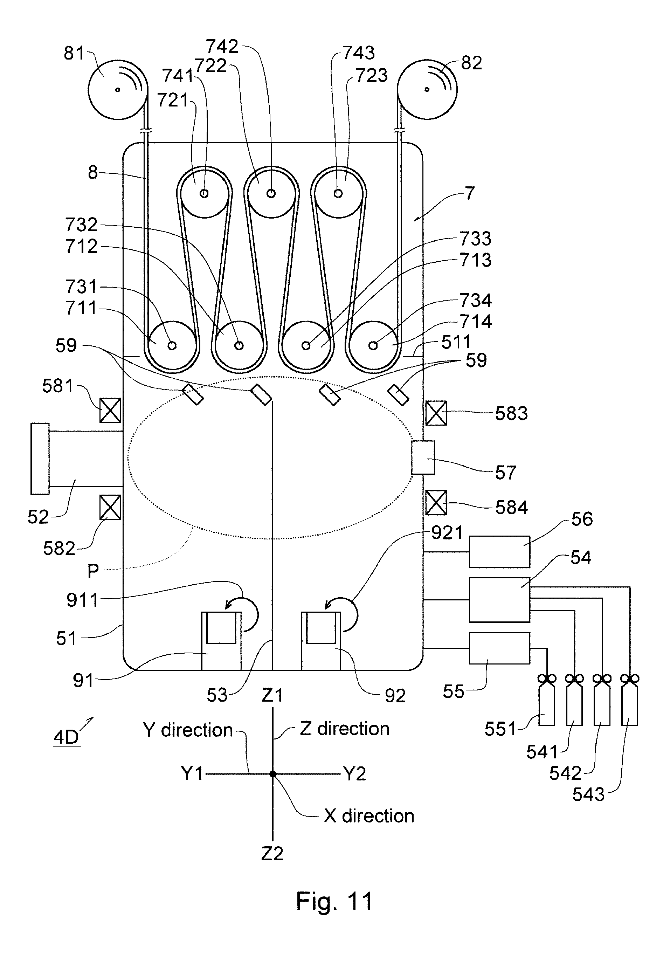

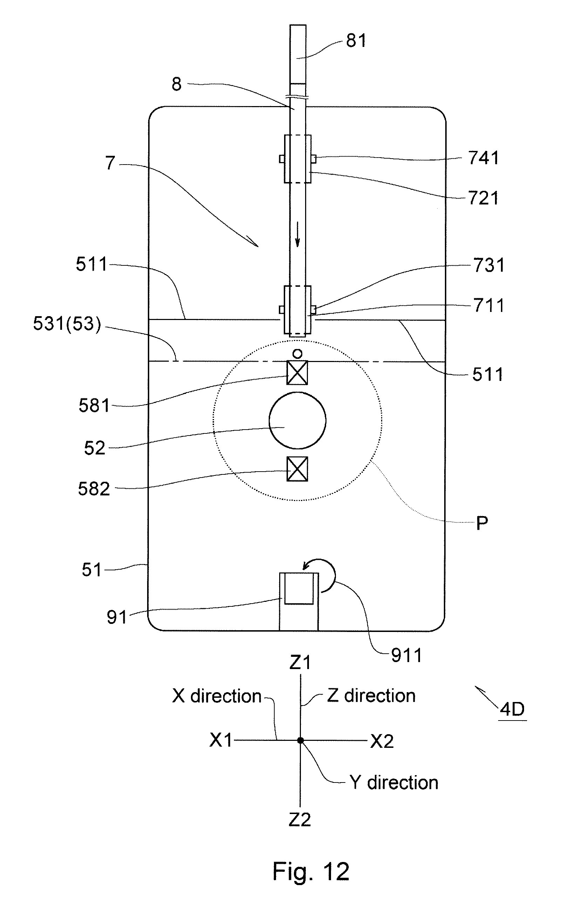

Fig. 11 is a front view of a production apparatus of the modification of the second embodiment seen from the X2 side in the X direction, and Fig. 12 is a left side view of the production apparatus seen from the Y1 side in the Y direction.

A conveyor 7 of this modification is similar to the conveyor 6 of the first embodiment in that the long belt-shaped resin substrate 8 is conveyed in its long direction by a roll-to-roll method, but the conveyor 7 has a conveyance mechanism different from that in the first embodiment.

Specifically, the conveyor 7 has a plurality of guide rollers 711 and 721 for feeding the long belt-shaped resin substrate 8 in the long direction. Some of the plurality of guide rollers are disposed in the thin film formation area for guiding the resin substrate 8 to the thin film formation area.

The conveyor 7 meanderingly conveys the resin substrate 8, and guides the resin substrate 8 to the thin film formation area and the non-formation area alternately. The conveyor 7 has a basic configuration in which there are a plurality of pairs of guide rollers (inside guide roller 711 and outside guide roller 721) that can be rotated so as to feed the long belt-shaped resin substrate 8 in its long direction as illustrated in Figs. 11 and 12.

The production apparatus 4D in the illustrated example is an apparatus capable of laminating two layers of a first thin film and two layers of a second thin film on the resin substrate 8, in which the number of the thin film is the same as the number of the inside guide rollers (first to fourth inside guide rollers 711, 712, 713, and 714) disposed in the thin film formation area. The inside guide rollers 711 disposed in the thin film formation area may be wholly included within the thin film formation area, or may be disposed so as to be partially included within the thin film formation area as illustrated in the figure.

On the other hand, the outside guide rollers 721 are disposed on the Z1 side with respect to the inside guide rollers 711, and the number thereof is smaller by 1 than the number of the inside guide rollers 711.

For the first to fourth inside guide rollers 711 to 714, for example, rollers having the same diameter and width can be used. For the first to third outside guide rollers 721, 722, and 723, for example, rollers having the same diameter and width can be used.

The first to fourth inside guide rollers 711 to 714 have independent rotating shafts 731, 732, 733, and 734, and are rotatably attached to the rotating shafts 731, 732, 733, and 734, respectively, and the first to third outside guide rollers 721, 722, and 723 also have independent rotating shafts 741, 742, and 743, and are rotatably attached to the rotating shafts 741, 742 and 743, respectively. Directions along which these rotating shafts 731 and 741 extend (axis directions) are all parallel to the X direction.

The first to fourth inside guide rollers 711 to 714 are arranged side by side in the Y direction at necessary intervals, and the first to third outside guide rollers 721, 722, and 723 are similarly arranged side by side in the Y direction at necessary intervals. The interval between adjacent inside guide rollers 711 is preferably as small as possible because the apparatus can be made smaller.

Similarly to the first embodiment, the first to fourth inside guide rollers 711 to 714 are each provided with a crystal monitor 59, and a temperature controller is attached as necessary.

The long belt-shaped resin substrate 8 drawn out from the roll 81 on the upstream side is fed from the Z1 side to the Z2 side, wound around the lower circumferential surface of the first inside guide roller 711, then fed from the Z2 side to the Z1 side, and wound around the upper circumferential surface of the first outside guide roller 721. When the resin substrate 8 is passing over the lower circumferential surface of the first inside guide roller 711, the resin substrate 8 is fed from the Y1 side to the Y2 side (in Y direction). When the resin substrate 8 is passing over the upper circumferential surface of the first outside guide roller, the resin substrate 8 is fed from the Y1 side to the Y2 side (in Y direction).

The long belt-shaped resin substrate 8 is wound around the upper circumferential surface of the first outside guide roller 721, then similarly wound around the second inside guide roller 712, the second outside guide roller 722, the third inside guide roller 713, the third outside guide roller 723, and the fourth inside guide roller 714 in this order, then fed from the Z2 side to the Z1 side, and wound around the roll 82 on the downstream side.

Therefore, the resin substrate 8 is fed while drawing a vertically meandering track as a whole as seen from the X1 side (see Fig. 11). That is, the conveyor 7 is configured to feed the resin substrate 8 while passing the resin substrate 8 through the thin film formation area and the non-formation area alternately, with the resin substrate 8 drawing a meandering conveyance track.

Two evaporation areas are disposed, for example.

First and second evaporation sources 91 and 92 are installed on the bottom of the chamber 51 so as to face the conveyor 6 (precisely, so as to face the resin substrate 8 at the time when the upper surfaces of evaporation sources 91 and 92 pass through the thin film formation area).

The first evaporation source 91 and the second evaporation source 92 are arranged side by side along a feeding direction of the resin substrate 8. In this modification example, the resin substrate 8 is fed in the Y direction (from Y1 side to Y2 side) in the thin film formation area, and therefore the first and second evaporation sources 91 and 92 are arranged in the Y direction. For example, the first evaporation source 91 is disposed on the Y1 side with respect to a substantially central part in the Y direction of a plurality of inside guide rollers 611, and the second evaporation source 92 is disposed on the Y2 side. The positions of the first evaporation source 91 and the second evaporation source 92 in the X direction may be the same, or may be mutually shifted, but are preferably the same.

The first evaporation source 91 and the second evaporation source 92 include different materials.

The partition wall 53 is interposed between the first evaporation source 91 and the second evaporation source 92. In the case of embodiments, the partition wall 53 is disposed so that the wall surface includes a Z direction and a X direction.

A method for producing a transparent gas barrier film will now be described.

The production apparatus 4D is operated, and when a resin substrate 8 sequentially passes through a thin film formation area (that is, when a resin substrate 8 passes through first to fourth inside guide rollers 711 to 714), the resin substrate 8 moves from a Y1 side to a Y2 side.

The long belt-shaped resin substrate 8 is drawn out from the roll 81 on the upstream side, and when the resin substrate 8 passes through the thin film formation area by way of the lower circumferential surface of the first inside guide roller 711, the material of the first evaporation source 91 is deposited on the surface of the resin substrate 8 and a first thin film is formed. The resin substrate 8 provided with the first thin film passes through the non-formation area by way of the circumferential surface of the first outside guide roller 721, and is then guided to the thin film formation area again by passing over the lower circumferential surface of the second inside guide roller 712. At this time, the material of the first evaporation source is deposited on the surface of the first thin film again, and a second layer of the first thin film is formed. Thereafter, the first layer of the second thin film is formed on the surface of the second layer of the first thin film, and the second layer of the second thin film is formed on the surface of the first layer of the second thin film (this is the layer configuration as described in Fig. 4).

According to this modification, a transparent gas barrier layer in which a plurality of thin films of two or more types (first and second thin films) having different components can be formed on the resin substrate 8.

According to the production method and the production apparatus of the second embodiment, the number of times the resin substrate passes through the thin film formation area can be appropriately changed.

In the second embodiment, a plurality of the inside guide rollers 711 having the same diameter are used, but the inside guide rollers 711 having mutually different diameters may also be used.

Furthermore, in the illustrated Fig. 2, a film is formed by guiding one resin substrate 8 into the chamber 51, but, for example, a transparent gas barrier layer may formed at once with respect to a plurality of the resin substrate 8 by arranging a plurality of the conveyor 7 side by side in a X direction in the chamber 51.

### [Third Embodiment of Production Method and Production Apparatus of the Present Invention]

The methods and apparatuses of the first and second embodiments can be appropriately changed in design within the intended scope of the present invention.

For example, by combining the arrangement of a plurality of evaporation sources described in the first embodiment and the arrangement of a plurality of evaporation sources described in the second embodiment, for example, a transparent gas barrier film can be produced which includes a transparent gas barrier layer including: a first laminated unit in which a plurality of laminated units each including a thin film of one type and a thin film of one type having a component different from that of the foregoing thin film are repeatedly laminated; and a second laminated unit in which a plurality of laminated units each including a thin film of one type having a component further different from those of the foregoing thin films and a thin film of one type having a component different from that of the foregoing thin film are repeatedly laminated.

In the above-mentioned vapor deposition method, the material is not necessarily deposited by application of a plasma by a plasma source, and use of a plasma is not necessarily required.

### EXAMPLES

Hereinafter, the present invention is further described in detail with Examples. Measurement and evaluation of various features and properties of Examples are performed by the following methods.

### [Water Vapor Transmission Rate]

The water vapor transmission rate (WVTR) was measured under an environment of a temperature of 40°C and a humidity of 90% RH using a water vapor transmission rate measurement device (manufactured by MOCON, Inc.; trade name "PERMATRAN") specified in JIS K7126.
The measuring range of the water vapor transmission rate measurement device is 0.005 g·m⁻²·day⁻¹ or more.

### [Thickness of Thin Film Forming Transparent Gas Barrier Layer]

The thickness of each thin film forming a transparent gas barrier film was determined by observing a cross section of a transparent gas barrier film with a scanning electron microscope (trade name: "JSM-6610") manufactured by JEOL Ltd., measuring a length from the surface of a substrate (film) to the surface of each thin film, and calculating the thickness.

### [Example]

A polyethylene naphthalate film (thickness: 100 µm; trade name "Teonex") manufactured by Teijin DuPont Films Japan Limited was prepared as a transparent resin film (resin substrate).

Next, the polyethylene naphthalate film was mounted on a conveyor of a production apparatus as illustrated in Figs. 5 and 6.

Silicon particles (purity 3N: 99.9%) were used as a material of a first evaporation source, and titanium particles (purity 4N: 99.9%) were used as a material of a second evaporation source in the production apparatus.

Argon (purity 5N) was introduced as a discharge gas into a plasma gun at a flow rate of 30 sccm, oxygen (purity 5N: 99.999%) was introduced as a reaction gas into a chamber at a flow rate of 10 sccm (10 × 1.69 × 10⁻³ Pa·m³/second), and in this state, the silicon particles were irradiated with an electron beam (acceleration voltage: 6 kV; applied current: 50 mA) to vaporize the silicon such that the deposition rate was 100 nm/min. At the same time, the titanium particles were irradiated with an electron beam (acceleration voltage: 6 kV; applied current: 50 mA) to vaporize the titanium such that the deposition rate was 100 nm/min. The pressure in the chamber at this time was 2.0 × 10⁻² Pa.

The polyethylene naphthalate film was helically fed by the conveyor in the chamber to prepare a transparent gas barrier film including a transparent gas barrier layer in which five first thin films 31h, 33h, 35h, 37h, and 39h and five second thin films 32i, 34i, 36i, 38i, and 310i were alternately laminated as illustrated in Fig. 7.

The first thin films formed in this example were all SiO films, and the second thin films were all TiO films.

The first thin films (SiO films) and the second thin films (TiO films) of the obtained transparent gas barrier film each had a thickness of 50 nm.

The transparent gas barrier film had a WVTR of 0.005 g·m⁻²·day⁻¹ or less (measurement limit of the water vapor transmission rate measurement device used).

1 Transparent gas barrier film
2 Resin substrate
3 Transparent gas barrier layer
4A, 4B, 4C, 4D Production apparatus of transparent gas barrier film
51 Chamber
52 Plasma source
91, 92 Evaporation source
54 Reaction gas supply device
6, 7 Conveyor
611, 621, 711, 721 Guide roller
8 Long belt-shaped resin substrate

## Claims

1. A method for producing a transparent gas barrier film using a roll-to-roll method, comprising:
laminating a plurality of thin films of two or more types having different components on a long belt-shaped resin substrate in the course of feeding the resin substrate, wherein
a plurality of evaporation sources are disposed in a thin film formation area, the number of the evaporation sources being the same as the number of types of the thin films, and
the long belt-shaped resin substrate is passed through the thin film formation area and a non-formation area alternately, and materials included in the plurality of evaporation sources are each deposited on the resin substrate in the thin film formation area to form on the resin substrate a transparent gas barrier layer having the plurality of laminated thin films of two or more types.

2. The method for producing a transparent gas barrier film according to claim 1, wherein the plurality of evaporation sources are arranged in the thin film formation area, and
in the thin film formation area, the resin substrate is fed in a direction along which the evaporation sources are arranged.

3. The method for producing a transparent gas barrier film according to claim 1 or 2, wherein the material included in each of the plurality of evaporation sources is different from one another, and the material contains at least one of a metal and a semimetal.

4. The method for producing a transparent gas barrier film according to any one of claims 1 to 3, wherein the materials are deposited on the resin substrate by a vacuum process method selected from a vapor deposition method, a sputtering method, and an ion plating method.

5. An apparatus for producing a transparent gas barrier film including a transparent gas barrier layer in which a plurality of thin films having different components are laminated in the thickness direction, the apparatus comprising:
a chamber having a thin film formation area and a non-formation area; a plurality of evaporation sources each including a material containing at least one of a metal and a semimetal; and a conveyor that feeds a long belt-shaped resin substrate, wherein
the plurality of evaporation sources are disposed in the thin film formation area, the number of evaporation sources being the same as the number of types of the thin films,
the plurality of evaporation sources, independently of one another, include different materials,
the plurality of evaporation sources are arranged side by side along a feeding direction of the long belt-shaped resin substrate or a direction orthogonally crossing the feeding direction, and
the conveyor is configured to feed the resin substrate so as to pass the resin substrate through the thin film formation area and the non-formation area alternately.

6. The apparatus for producing a transparent gas barrier film according to claim 5, wherein the conveyor is configured to feed the long belt-shaped resin substrate so as to draw a helical conveyance track.

7. The apparatus for producing a transparent gas barrier film according to claim 5 or 6, wherein the plurality of evaporation sources are arranged side by side along the feeding direction of the long belt-shaped resin substrate.

8. The apparatus for producing a transparent gas barrier film according to any one of claims 5 to 7, the apparatus further comprising a plasma source that generates a plasma; and a reaction gas supply device that supplies a reaction gas, in the chamber.
